Europäisches Patentamt

European Patent Office

Office européen des brevets

(11) Numéro de publication: **0 031 769**
**B1**

(12) **FASCICULE DE BREVET EUROPEEN**

(45) Date de publication du fascicule du brevet:
**14.03.84**

(21) Numéro de dépôt: **80401825.7**

(22) Date de dépôt: **18.12.80**

(51) Int. Cl.³: **G 01 R 23/14,** G 01 R 23/163,
H 03 D 9/06

(54) **Perfectionnements aux échantillonneurs à très large bande.**

(30) Priorité: **27.12.79 FR 7931798**

(43) Date de publication de la demande:
**08.07.81 Bulletin 81/27**

(45) Mention de la délivrance du brevet:
**14.03.84 Bulletin 84/11**

(84) Etats contractants désignés:
**DE GB IT**

(56) Documents cités:
**DE - B - 1 061 392**
**DE - B - 1 137 486**

(73) Titulaire: **LIGNES TELEGRAPHIQUES ET
TELEPHONIQUES L.T.T., 1, rue Charles Bourseul,
F-78702 Conflans-Ste-Honorine (FR)**

(72) Inventeur: **Prevot, Julien, THOMSON-SCF SCPI 173, Bld
Haussmann, F-75360 Paris Cedex 08 (FR)**

(74) Mandataire: **Benoit, Monique et al, THOMSON-CSF
SCPI 173, Bld Haussmann, F-75379 Paris Cedex 08 (FR)**

BUNDESDRUCKEREI BERLIN

## Perfectionnements aux échantillonneurs à tres large bande

La présente invention concerne un échantillonneur couvrant une bande de fréquences s'étendant depuis l'extrémité inférieure du spectre des fréquences jusqu'à plusieurs dizaines de gigahertz. Dans ce qui suit, on apelle échantillonneur, conformément à l'usage qui est fait de ce terme en métrologie, un circuit comportant une source locale d'impulsions brèves, dont le spectre est constitué d'une suite discrète de raies à des fréquences multiples de la fréquence de récurrence, associée à un élément non linéaire assurant le battement avec un signal appliqué dont la fréquence est à déterminer. Un filtre de sortie basse fréquence transmet le signal à la fréquence de battement (entre celle du signal appliqué et celle d'une raie du spectre de la source locale) située dans sa bande passante, en vue de la mesure. La détermination de la fréquence exige donc la détermination de la raie qui a participé au battement. Cette opération relève du traitement de données et a fait l'objet de publications, notamment de l'article publié dans le numéro de mai 1978 du Hewlett Packard Journal: »Microprocessor-controlled harmonic heterodyne microwave counter also measures amplitude«. La réalisation d'un tel échantillonneur met en œuvre un ensemble de circuits relativement complexe, la complexité augmentant lorsque la largeur de la gamme de fréquences à couvrir croît. L'évolution actuelle de la technique conduisant à l'utilisation de fréquences de plus en plus élevées, il est nécessaire que les appareils de mesure opèrent dans une bande de fréquences de plus en plus large. La diffusion de ces appareils nécessite un prix de revient aussi faible que possible.

Ainsi qu'il est précisé dans l'article cité, le composant le plus cher est l'échantillonneur. La présente invention a pour objet la réalisation simple d'un tel circuit, permettent une réduction du prix de revient de l'ensemble de mesure.

La présente invention repose sur l'utilisation des propriétés des guides d'ondes, et plus particulièrement des guides d'ondes à section rectangulaire, comme filtre passe-haut. Elle est plus particulièrement caractérisée en ce qu'un même tronçon de guide d'onde est utilisé à la transmission des impulsions de la source locale, au filtrage par élimination des composantes à basse fréquence du spectre, au battement avec le signal dont la fréquence est à mesurer dans un circuit connu constitué de deux diodes disposées en série dans ledit tronçon de guide.

Il est connu par les publications de brevet DE-B-1 061 392 et DE-B-1 337 486 des montages mélangeurs hyperfréquences pour faire battre une fréquence $f_1$ avec une fréquence $f_2$ pour obtenir la fréquence de battement $f_3$ désirée. Ces montages utilisent un tronçon de guide rectangulaire ouvert à une extrémité pour recevoir la fréquence $f_1$ et fermé à son autre extrémité avec aménagement d'une entrée coaxiale pour recevoir la fréquence $f_2$. Le conducteur central de l'entrée coaxiale se prolonge dans le guide pour y constituer un barreau cylindrique (ou parallélépipédique) dont l'axe coïncide avec celui au guide et pour connecter cette entrée à deux éléments non linéaires (ou deux diodes montées tête-bêche) placés dans une section droite du guide.

Ces montages n'utilisent pas notamment la fonction de filtrage passe-haut du guide pour éliminer des composants à basse fréquence du spectre du signal émis par la source locale. De plus ils peuvent comporter des capacités qui interdisent le passage du continu.

Suivant l'invention on se propose de réaliser un échantillonneur à très large bande, comportant: une source d'impulsions brèves de fréquence de récurrence F et de durée t déterminées pour produire un spectre de raies à des fréquences multiples nF, n étant un entier, de celle de récurrence, la source étant constituée au moyen d'une première diode définissant ladite fréquence de récurrance Fet ladite durée t connectée à un circuit générateur à haute fréquence annexe; et un circuit non linéaire couplé à la première diode et constitué par une deuxième et une troisième diodes connectées en série par un conducteur également relié à une entrée de réception du signal à analyser et à une résistance d'adaption, chacune de ces deuxième et troisième diodes étant connectée par son extrémité autre que celle reliée à l'autre diode à une sortie associée à travers un circuit basse-fréquence; l'échantillonneur étant caractérisé en ce qu'il est réalisé en circuit hyperfréquence pour couvrir une bande allant du continu à plusieurs dizaines de gigahertz en utilisant un tronçon de guide d'ondes de secteur droite rectangulaire et invariable le long de la direction de propagation des ondes, avec la première diode positionnée dans une première section droite dudit guide d'onde, et avec les deuxième et troisième diodes ainsi que l'axe du conducteur les reliant en série positionnés dans une deuxième section droite dudit guide d'onde, cet axe étant à égale distance des grandes faces du guide, chacune desdites deuxième et troisième diodes étant disposée respectivement entre une grande face du guide et le conducteur et étant située dans la zone de maximum d'intensité du champ électrique de ladite deuxième section droite, les ondes transmises par la première diode vers la deuxième section droite comportant seules les raies de rang supérieur à une valeur pré-déterminée par suite de l'effet de filtrage haute-fréquence du guide, ledit tronçon étant fermé à chaque extrémité par une charge absorbante.

Selon l'invention, la source d'impulsions est une diode disposée dans ledit tronçon de guide et placée de la même façon que les diodes mélangeuses dans une section droite du guide.

L'échantillonneur selon l'invention est particulièrement simple à réaliser, d'encombrement réduit et de grande robustesse, ce qui le rend particulièrement adapté à une utilisation comme appareil de mesure.

L'invention sera bien comprise en se reportant à la description suivante et aux figures qui l'accompagnent données à titre d'illustration non limitative et dans lesquelles:

— la figure 1 est le schéma d'un circuit équivalent à l'échantillonneur;

— la figure 2 est une vue en coupe longitudinale de l'ensemble échantillonneur;

— la figure 3 est une vue en coupe transversale du guide au niveau des diodes mélangeuses.

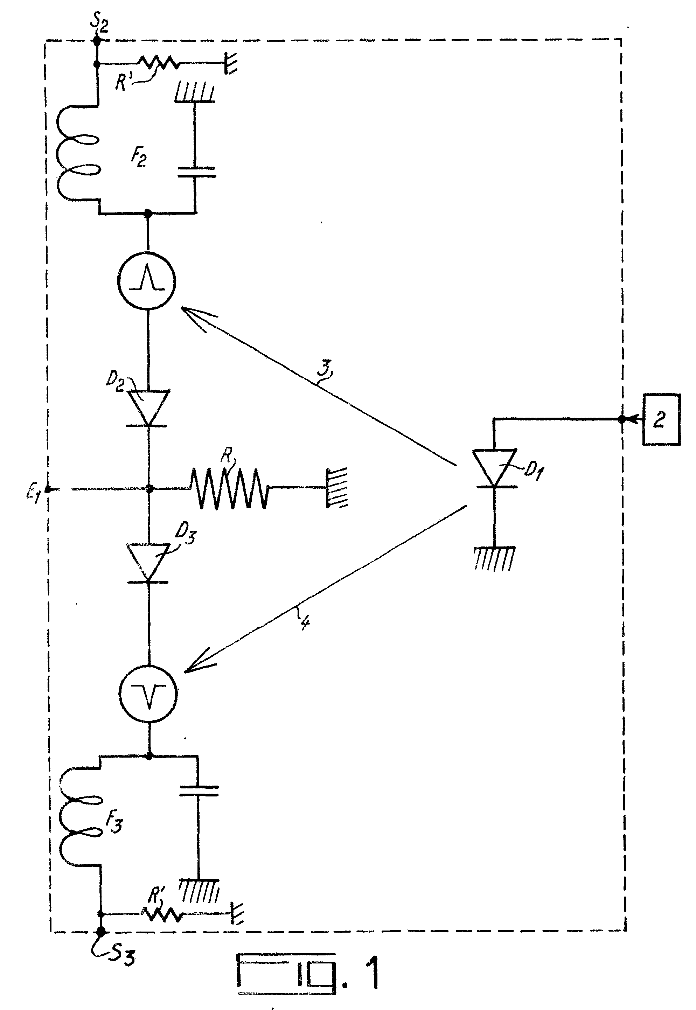

On a représenté sur la figure 1 le schéma équivalent au circuit d'échantillonnage. Ce circuit est connu en soi. On a figuré l'oscillateur local découpant des impulsions dans l'énergie à haute fréquence fournie par une source 2. La diode $D_1$ définit la forme et la fréquence de récurrence des impulsions. Celles-ci sont transmises au circuit mélangeur constitué essentiellement des diodese $D_2$ et $D_3$ connectées en série. Le couplage entre $D_1$ et le circuit mélangeur est représenté schématiquement par les flèches 3 et 4. Chacune des diodes $D_2$ et $D_3$ est connectée à une sortie basse fréquence $S_2$ et $S_3$ respectivement par l'intermédiaire d'un filtre passe-bas, respectivement $F_2$ et $F_3$, constitué par une inductance et un condensateur. Les diodes sont auto-polarisées par les résistances $R'$. Le signal dont la fréquence doit être mesurée est appliqué en $E_1$. La résistance R connectée au point commun aux deux diodes assure l'adaptation de l'impédance en $E_1$. Le schéma correspond à un circuit bien connu de l'homme du métier, l'invention résidant dans la réalisation du circuit en technologie guide d'onde.

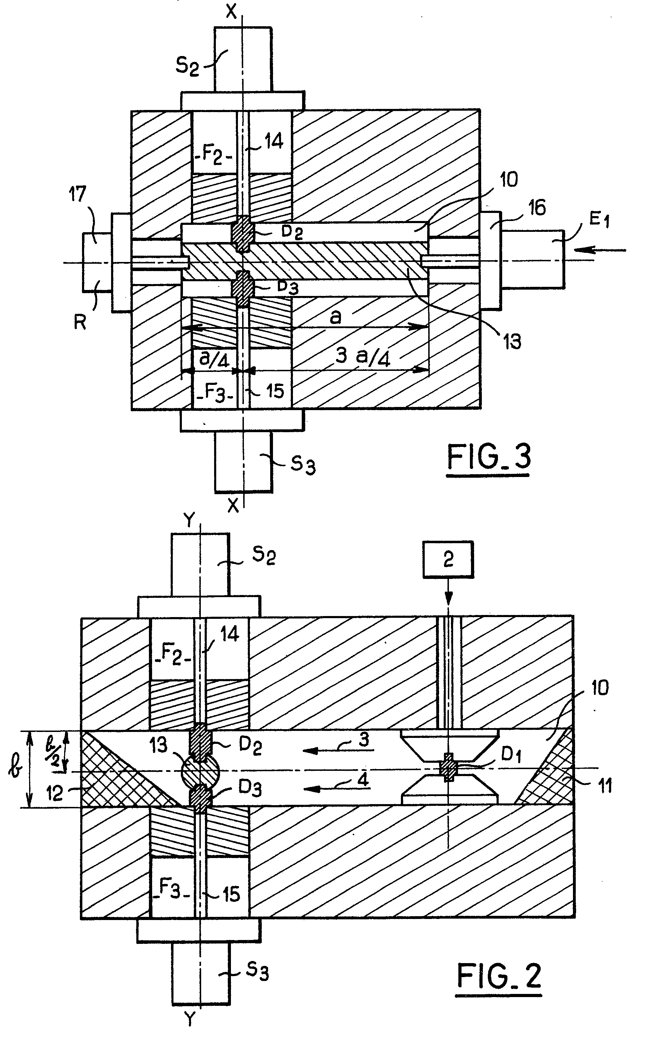

Les figures 2 et 3 correspondent à une variante préférée de réalisation de l'invention. Ainsi qu'il apparaît sur la figure 2, la source d'impulsions, constituée par une diode $D_1$, associée à la source 2 d'onde entretenue, est disposée dans un guide d'onde 10 de section rectangulaire. A proximité de la diode $D_1$ est disposée une charge 11 absorbant l'énergie qui se propage vers la droite dans le guide. L'énergie se propageant vers la gauche est transmise dans le guide 10 suivant les flèches 3 et 4 vers les diodes $D_2$ et $D_3$ constituant le circuit non linéaire à un niveau fixe, indépendant de la fréquence de la source 2. La partie de guide comprise entre $D_1$ et $D_2$—$D_3$ joue le rôle d'un filtre passe-haut ne transmettant que les raies à fréquence élevée du spectre fréquence des impulsions issues de la diode $D_1$. Selon un mode de réalisation préféré, seules les raies de rang supérieur à 7 (sans que cette valeur soit limitative) sont transmises par le guide sans atténuation. Il est bien connu que la fréquence de coupure du guide est uniquement définie par les dimensions a et b de sa section droite. Une deuxième charge 12 est disposée à la gauche du circuit non linéaire de façon à éviter toute réflexion de l'énergie qui n'a pas été utilisée. Les diodes $D_2$ et $D_3$

sont mécaniquement solidaires d'un barreau 13 disposé suivant la grande dimension du guide, perpendiculairement à la direction de propagation, ainsi qu'on le voit mieux sur la figure 3. L'une des électrodes de chaque diode est en contact avec ce barreau conducteur. L'autre électrode de chacune des diodes est connectée au conducteur central, respectivement 14 et 15, d'une ligne coaxiale se terminant par une sortie coaxiale, respectivement $S_2$ et $S_3$. Les filtres $F_2$ et $F_3$ sont constitués, ainsi qu'il est bien connu, par le tronçon de ligne coaxiale disposée entre la diode et la sortie associée. Ainsi qu'il apparaît mieux sur la figure 3, le barreau 13 est maintenu parallèlement aux grandes parois du guide rectangulaire 10 entre le conducteur central du connecteur 16 constituant l'entrée $E_1$ et la charge adaptée 17.

Les traces des plans de coupe des figures 2 et 3 sont représentées respectivement en YY et XX sur l'autre figure. Ainsi qu'il apparaît sur la figure 3, les diodes $D_2$ et $D_3$ sont disposées dans la section droite rectangulaire du guide 10, non pas suivant l'axe de symétrie, mais à une distance de la petite paroi gauche égale à un quart de la grande dimension du guide. Cet arrangement particulier favorise le fonctionnement du circuit échantillonneur à fréquence élevée. En effet, l'énergie qui se propage dans le guide 10 sans atténuation est constituée de la partie supérieure du spectre des impulsions formées par $D_1$. Divers modes de propagation s'établissent donc dans le guide; la répartition de champ électrique dans la section droite diffère d'un mode à un autre ainsi qu'il est connu. La localisation des diodes mélangeuses dans le plan de symétrie du guide correspond à la localisation des diodes au maximum d'intensité du champ électrique pour le mode fondamental $TE_{01}$. La localisation des diodes à une distance d'un petit côté égal à 1/4 de la grande dimension du guide place les diodes au voisinage du maximum de champ électrique pour le mode d'ordre 2. La position choisie correspond à une intensité élevée des répartitions de champs des trois premiers modes $TE_{0n}$. Le positionnement des diodes est un compromis entre le rapprochement d'un petit côté du guide qui correspond au maximum de champ électrique des modes supérieurs et la diminution de la valeur du champ maximal avec le rang du mode.

Le conducteur 13 du mode de réalisation préféré qui vient d'être décrit est une tige de section circulaire et de longueur égale à la plus grande dimension du guide. La forme du conducteur 13 n'intervient que peu. Il peut être constitué d'une bande métallique ou d'un barreau de section quelconque sans différence notable des caractéristiques de l'échantillonneur. La section droite du conducteur 13 influe sur l'impédance à l'entrée $E_1$ de l'échantillonneur.

Dans une réalisation particulière, on a utilisé:

— diode $D_1$: une diode HP 5082-885 de chez Hewlett-Packard
— diodes $D_2$ et $D_3$: des diodes 5022-2711 de chez Hewlett-Packard
- une source 2: à 1 GHz ± 50 MHz pour faciliter le comptage
- une charge adaptée 17: du type EMC 8021-3
- le conducteur 13 est une tige de laiton de 3,2 millimètres de diamètre
- le guide 10 a des dimensions: a = 20 millimètres, b = 5,8 millimètres

Un tel échantillonneur délivre un niveau constant à ±2 dB lorsque la fréquence du signal appliqué est une onde sinusoïdale couvrant la bande de fréquences comprise entre 0,1 et 24 GHz.

## Revendications

1. Echantillonneur à très large bande, comportant: une source ($D_1$) d'impulsions brèves de fréquence de récurrence F et de durée t déterminées pour produire un spectre de raies à des fréquences multiples nF, n étant un entier, de celle de récurrence, la source étant constituée au moyen d'une première diode ($D_1$) définissant ladite fréquence de récurrence F et ladite durée t connectée à un circuit générateur à haute fréquence (2) annexe; et un circuit non linéaire couplé à la première diode et constitué par une deuxième et une troisième diodes ($D_2$, $D_3$) connectées en série par un conducteur (13) également relié à une entrée ($E_1$) de réception du signal à analyser et à une résistance d'adaptation (R), chacune de ces deuxième et troisième diodes étant connectée par son extrémité autre que celle reliée à l'autre diode à une sortie associée (S2, S3) à travers un circuit basse-fréquence (F2, $F_3$); l'échantillonneur étant caractérisé en ce qu'il est réalisé en circuit hyperfréquence pour couvrir une bande allant du continu à plusieurs dizaines de GHz en utilisant un tronçon de guide d'ondes (10) de section droite rectangulaire et invariable le long de la direction de propagation des ondes, avec la première diode positionnée dans une première section droite dudit guide d'onde, et avec les deuxième et troisième diodes ainsi que l'axe du conducteur (13) les reliant en série positionnés dans une deuxième section droite dudit guide d'onde, cet axe étant à égale distance (b/2) des grandes faces du guide, chacune desdites deuxième et troisième diodes étant disposée respectivement entre une grande face du guide et le conducteur et étant située dans la zone de maximum d'intensité du champ électrique de ladite deuxième section droite, les ondes transmises (3-4) par la première diode vers la deuxième section droite comportant seules les raies de rang supérieur à une valeur pré-déterminée par suite de l'effet de filtrage haute-fréquence du guide, ledit tronçon étant fermé à chaque extrémité par une charge absorbante (11, 12).

2. Echantillonneur selon la revendication 1, caractérisé en ce que la première et la deuxième diodes ($D_2$, $D_3$) sont situées à une distance (a/4)

d'une petite face du guide égale à 1/4 de la grande dimension (a) du guide.

3. Echantillonneur selon la revendication 1 ou 2, caractérisé en ce que le conducteur (13) est un barreau métallique de section droite circulaire.

4. Echantillonneur selon la revendication 1 ou 2, caractérisé en ce que le conducteur (13) est un barreau métallique de section droite rectangulaire.

## Patentansprüche

1. Sehr breitbandiger Abtaster, enthaltend: eine Impulsquelle ($D_1$) zur Abgabe von kurzen Impulsen mit der bestimmten Wiederholungsfrequenz F und bestimmten Dauer t, zur Erzeugung eines Spektrums von Frequenzlinien mit Frequenzen nF, worin n eine ganze Zahl ist, die ein Vielfaches der Wiederholungsfrequenz sind, wobei die Quelle gebildet ist mittels wenigstens einer ersten Diode ($D_1$), welche die Wiederholungsfrequenz F und die Dauer t festlegt und an eine Hochfrequenz-Hilfsgeneratorschaltung (2) angeschlossen ist; und eine nicht lineare Schaltung, welche an die erste Diode angekoppelt ist und gebildet ist aus einer zweiten und aus einer dritten Diode ($D_2$, $D_3$), die über einen Leiter (13) in Reihe geschaltet sind, der ferner an einen Eingang ($E_1$) zum Empfang des zu analysierenden Signals sowie an einen Anpassungswiderstand (R) angeschlossen ist, wobei die zweite und dritte Diode jeweils an ihrem Ende, welches dem mit der anderen Diode verbundenen gegenüberliegt, an einen zugeordneten Ausgang (S2, S3) über eine Niederfrequenzschaltung (F2, $F_3$) angeschlossen sind; wobei der Abtaster dadurch gekennzeichnet ist, daß er als Mikrowellenschalter verwirklicht ist, um ein Band zu überdecken, welches vom Gleichspannungsbereich bis zu mehreren zehn GHz reicht, unter Verwendung eines Wellenleiterabschnitts (10) mit rechtwinkligem senkrechten Querschnitt, der entlang der Ausbreitungsrichtung der Wellen invariabel ist, wobei die erste Diode in einem ersten senkrechten Querschnitt des Wellenleiters angeordnet ist, während die zweite und die dritte Diode sowie die Achse des sie in Reihe schaltenden Leiters (13) in einem zweiten senkrechten Querschnitt des Wellenleiters angeordnet sind, wobei diese Achse in gleichem Abstand (b/2) von den Hauptflächen des Wellenleiters liegt, wobei die zweite und die dritte Diode jeweils zwischen einer der Hauptflächen des Wellenleiters und dem Leiter angeordnet sind und in der Zone maximaler Intensität des elektrischen Feldes des genannten zweiten senkrechten Querschnitts liegen, wobei die durch die erste Diode zu dem zweiten senkrechten Querschnitt übertragenen Wellen (3-4) aufgrund der Hochfrequenz-Filterwirkung des Wellenleiters allein die Frequenzlinien einer Ordnungszahl enthalten, die höher ist als ein vorbestimmter Wert, und wobei der Abschnitt an jedem Ende durch eine absorbierende Belastung (11, 12) verschlossen ist.

2. Abtaster nach Anspruch 1, dadurch gekennzeichnet, daß die erste und die zweite Diode ($D_2$, $D_3$) in einem Abstand ($a/4$) von einer kleinen Fläche des Wellenleiters liegen, die gleich einem Viertel der großen Abmessung ($a$) des Wellenleiters ist.

3. Abtaster nach Anspruch 1 oder 2, dadurch gekennzeichnet, daß der Leiter (13) ein Metallstab mit rundem senkrechten Querschnitt ist.

4. Abtaster nach Anspruch 1 oder 2, dadurch gekennzeichnet, daß der Leiter ein Metallstab rechtwinkligen senkrechten Querschnitts ist.

## Claims

1. Very wide band sampler comprising: a source ($D_1$) of short pulses of defined recurrence frequency F and width t, for producing a spectrum of frequency lines with frequencies nF, n being an integer, which are a multiple of the recurrence frequency, the source being formed by a first diode ($D_1$) defining said recurrence frequency F and said width t and connected to anauxiliary high-frequency generator circuit (2); and a non-linear circuit coupled to the first diode and formed by a second and a third diode ($D_2$, $D_3$) connected in series by a conductor (13) likewise connected to an input ($E_1$) for receiving the signal to be analysed and to an adaptation resistor (R), each of said second and third diodes being connected by its end other than that connected to the other diode to an associated output (S2, S3) via a low-frequency circuit ($F_2$, $F_3$; the sampler is characterized in that it is realized as hyperfrequency circuit for covering a band ranging from the DC voltage range to several tens of GHz using a wave guide section (10) with rectangular cross-section invariable along the direction of propagation of the waves, the first diode being positioned in a first cross-section of said wave guide, and the second and third diodes and the axis of the conductor (13) connecting them in series being positioned in a second cross-section of said wave guide, said axis being at an equal distance ($b/2$) from the major faces of the wave guide, each of said second and third diodes being disposed respectively between a major face of the wave guide and the conductor and being situated in the zone of maximum intensity of the electric field of said second cross-section, the waves (3-4) transmitted by the first diode to the second cross-section containing only the lines of an order higher than a predetermined value as a consequence of the high-frequency filter effect of the wave guide, said section being closed at each end by an absorbing load (11, 12).

2. Sampler according to Claim 1, characterized in that the first and the second diodes ($D_2$, $D_3$) are situated at a distance ($a/4$) from a minor face of the wave guide equal to 1/4 of the major dimension ($a$) of the wave guide.

3. Sampler according to Claim 1 or 2, characterized in that the conductor (13) is a metal rod of circular cross-section.

4. Sampler according to Claim 1 or 2, characterized in that the conductor (13) is a metal rod of rectangular cross-section.

FIG. 1

**FIG. 3**

**FIG. 2**

9